# DEMANDE DE BREVET EUROPEEN

(11) **EP 1 898 426 A2**
(43) Date de publication de la demande: **12.03.2008**
(21) Numéro de dépôt: 07015337.4
(22) Date de dépôt: 06.08.2007
(51) Int. Cl.: G11C 16/02

(54) **Mémoire à changement de phase effacable et programmable au moyen d' un décodeur de ligne**

(30) Priorité: 05.09.2006 FR 0607744
(71) Demandeur: STMICROELECTRONICS SA, 92120 Montrouge (FR)
(72) Inventeur: Giovanazzi, Thierry, 83470 Saint Maximin (FR); La Rosa, Francesco, 13790 Rousset (FR)
(74) Mandataire: Marchand, André

(57) **Abrégé**

L'invention concerne un circuit intégré comprenant une mémoire non-volatile comportant des cellules mémoire (CEL) comprenant chacune un point mémoire (P) et un transistor de sélection (TS) ayant une borne de contrôle connectée à une ligne de mot (WL), un décodeur de ligne (RDEC) pour fournir des signaux (SWL) de sélection de lignes de mot, et au moins un générateur (LTC) pour fournir à des cellules mémoire une tension (Vp) ou un courant (Ip) d'effacement ou de programmation. Selon l'invention des pilotes de ligne de mot (DRV) sont interposés entre le décodeur de ligne et les lignes de mot, et sont agencés pour appliquer à une ligne de mot sélectionnée par le décodeur de ligne des impulsions de contrôle (VPULSEi) dont le profil correspond à un profil d'impulsion de tension ou de courant d'effacement ou de programmation. Application notamment aux mémoires à changement de phase.

## Description

La présente invention concerne le domaine des mémoires non-volatiles programmables et effaçables électriquement et notamment les mémoires comprenant des cellules mémoire à changement de phase (PCM).

Les points mémoire à changement de phase sont composés d'un matériau pouvant changer d'état physique sous l'effet d'un signal électrique, et plus précisément sous l'effet d'une élévation de température provoquée par une tension et un courant électrique (effet Joule). Ce changement d'état est rémanent et s'accompagne d'un changement des propriétés électriques du point mémoire. Dans une première phase dite amorphe le matériau présente une résistivité électrique élevée, et dans une seconde phase dite cristalline le matériau présente une faible résistivité électrique.

Les progrès réalisés sur les compositions de matériaux à changement de phase, par exemple des alliages à base d'éléments chimiques de la colonne VI de la table de Mendeleïev, comme le tellure Te ou le sélénium Se, sont tels que le changement de phase peut être obtenu avec une tension de quelques Volt et un courant de quelques centaines de microampères seulement, ce qui permet l'intégration de points mémoire à changement de phase dans les mémoires implantées sur microplaquette de semi-conducteur.

A titre d'exemple, la figure 1 représente l'architecture d'un plan mémoire MA du type décrit par EP 1 450 373. Le plan mémoire MA comprend des cellules mémoire CELi,j,k agencées de façon matricielle et reliées chacune à une ligne de mot WLi de rang i et à une ligne de bit BLjk de rang j (j allant de 0 à m) appartenant à une colonne COLk de rang k. Chaque cellule mémoire CELi,j,k comprend un interrupteur de sélection TS, par exemple un transistor NMOS, et un point mémoire P à changement de phase. L'anode du point mémoire P est reliée à une ligne de bit BLjk et sa cathode est reliée par l'intermédiaire du transistor TS à un potentiel bas ou à une ligne commutable à un potentiel bas, par exemple la masse. La borne de grille du transistor TS est reliée à une ligne de mot WLi.

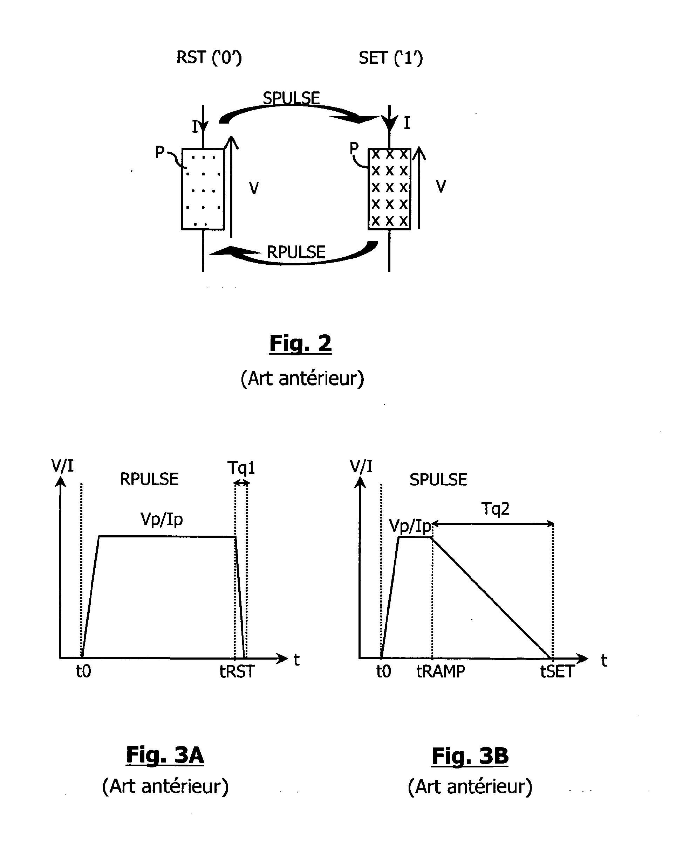

Comme illustré sur la figure 2, le point mémoire P présente deux états stables SET et RST (contraction de "RESET") correspondant aux deux types de résistivité précités. Dans l'état SET qui correspond par exemple à la mémorisation d'un "1" logique, le point mémoire présente une première résistance série, par exemple 5 à 10 KΩ, tandis que dans l'état RST correspondant à la mémorisation d'un "0" logique, le point mémoire présente une seconde résistance série, par exemple 100 à 200 KΩ.

Par analogie avec les mémoires effaçables et programmables électriquement utilisant des transistors à grille flottante, on appellera "état programmé" l'état SET et "état effacé" l'état RST. Le passage de l'état programmé à l'état effacé est assuré en appliquant au point mémoire une impulsion RPULSE du type représenté sur la figure 3B, présentant un plateau d'une durée tRST de quelques dizaines de nanosecondes, par exemple 100 nanosecondes, et un temps d'extinction Tq1 ("Tquench") aussi rapide que possible, ne devant pas excéder en pratique quelques nanosecondes. L'impulsion RPULSE est contrôlée en tension ou en courant et présente une tension maximale Vp de quelques Volt et un courant maximal Ip de quelques centaines de microampères, qui provoquent par effet Joule un échauffement rendant le matériau amorphe.

Le passage de l'état effacé à l'état programmé est assuré en appliquant au point mémoire une impulsion SPULSE du type représenté sur la figure 3B, d'une durée tSET. L'impulsion présente un plateau de quelques dizaines de nanosecondes, par exemple 50 nanosecondes, et un temps d'extinction Tq2 assez long, par exemple 300 nanosecondes. Ainsi l'impulsion SPULSE présente une rampe décroissante à partir d'un instant tRAMP calculé à compter de l'instant t0 de son émission, la durée de la rampe étant égale à tSET-tRAMP. L'impulsion SPULSE est également contrôlée en tension ou en courant et présente une tension maximale Vp de quelques Volt et un courant maximal Ip de quelques centaines de microampères, suivi de la rampe de tension ou de courant décroissante qui a pour effet de faire recristalliser le matériau.

En résumé, le temps d'extinction Tq2 de l'impulsion SPULSE est assez long tandis que le temps d'extinction Tq1 de l'impulsion RPULSE doit au contraire être très court pour empêcher la recristallisation.

Une lecture du point mémoire P permet ensuite de déterminer si ce dernier présente la première ou la seconde résistance série, et une valeur binaire 1 ou 0 est associée à la valeur de résistance lue. Une telle lecture est généralement conduite sous une tension faible afin de ne pas modifier l'état du point mémoire en provoquant un effacement ou une programmation parasite. Une tension de lecture de faible valeur, par exemple 0,5 V, est suffisante pour lire le point mémoire tout en étant suffisamment faible pour ne pas provoquer un changement de l'état programmé ou effacé du point mémoire.

L'intégration de points mémoire à changement de phase dans une mémoire réalisée sur un substrat de semi-conducteur est un objectif essentiel pour l'exploitation industrielle de cette technologie de mémoire, en raison du faible prix de revient des circuits intégrés. A cet effet les moyens de contrôle des cellules mémoire, notamment les moyens d'effacement et de programmation, doivent être réalisés de façon rationnelle, peu coûteuse et peu encombrante en termes de surface de semi-conducteur.

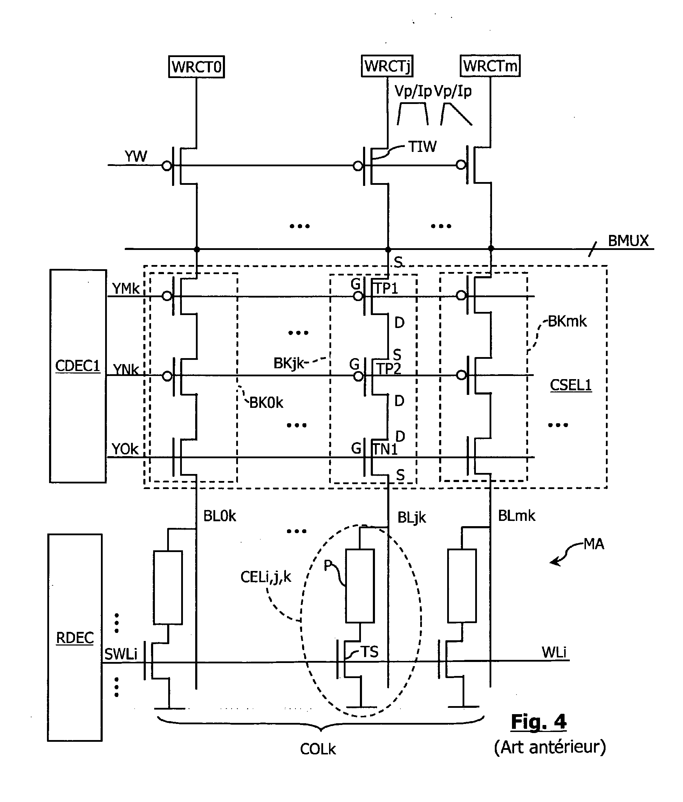

La présente invention vise à perfectionner les moyens d'effacement et de programmation proposés dans l'art antérieur. Pour fixer les idées sur les solutions prévues dans l'art antérieur, la figure 4 représente une architecture classique de mémoire à changement de phase du type décrit par la demande EP 1 450 373. La mémoire représentée comprend un plan mémoire MA et des cellules mémoire du type décrit plus haut. La mémoire comprend également un circuit de sélection de colonne CSEL1 connecté aux lignes de bit BL (BL0k, ...BLjk,... BLmk). Le circuit de sélection CSEL1 comprend des blocs BK de sélection de ligne de bit (BK0k,...BKjk,...BKmk) à raison d'un bloc par ligne de bit. Chaque bloc de sélection BK comprend en série des transistors TP1, TP2 de type PMOS et un transistor TN1 de type NMOS. Ces transistors sont contrôlés par des signaux de sélection YMk, YNk, YOk fournis par un décodeur de colonne CDEC1.

Pendant des phases d'effacement ou programmation de cellules mémoire, les impulsions RPULSE ou SPULSE sont fournies par des circuits d'écriture WRCT (WRCT0,...WRCTj,...WRCTm). Les impulsions RPULSE ou SPULSE sont appliquées aux lignes de bit par l'intermédiaire de transistors d'isolement TIW, d'un bus de multiplexage BMUX et des blocs de sélection BK. A cet effet, les transistors d'isolement TIW sont mis dans l'état passant au moyen d'un signal de grille YW, les signaux YM et YN sont mis à 0 (masse du circuit) et le signal YO est porté à une tension de grille de forte valeur afin que la tension Vp ou le courant Ip soit transféré sans perte. Simultanément, un décodeur de ligne RDEC applique à une ligne de mot WLi un signal de sélection SWLi qui polarise les grilles des transistors de sélection TS des cellules mémoire connectées à cette ligne de mot, et met ces transistors dans l'état passant.

Cette méthode d'effacement programmation présente le désavantage d'être relativement complexe à mettre en oeuvre. Notamment, les circuits d'écriture WRCT sont complexes à réaliser car le profil et la durée des impulsions RPULSE ou SPULSE doivent être contrôlés avec grande précision, notamment les temps d'extinction Tq1 et Tq2.

La présente invention vise ainsi un procédé pour appliquer de façon simple à des cellules mémoire des impulsions de tension ou de courant présentant des durées, des profils et des temps d'extinction déterminés.

La présente invention vise également une mémoire comprenant des moyens de mise en oeuvre de ce procédé.

A cet effet, la présente invention prévoit un circuit intégré comprenant une mémoire non-volatile comportant des cellules mémoire comprenant chacune un point mémoire et un transistor de sélection ayant une borne de contrôle connectée à une ligne de mot, un décodeur de ligne pour fournir des signaux de sélection de lignes de mot, au moins un générateur de tension ou courant pour fournir à des cellules mémoire une tension ou un courant d'effacement ou de programmation, et des pilotes de ligne de mot interposés entre le décodeur de ligne et les lignes de mot, agencés pour appliquer à une ligne de mot sélectionnée par le décodeur de ligne des impulsions de contrôle dont le profil correspond à un profil d'impulsion de tension ou de courant d'effacement ou de programmation à appliquer à des points mémoire, et contrôler ainsi au moyen des transistors de sélection l'amplitude et la durée de la tension ou du courant d'effacement ou de programmation appliqué aux points mémoire.

Selon un mode de réalisation, le circuit intégré comprend un circuit de contrôle fournissant aux pilotes de ligne de mot un premier signal de contrôle dont le profil détermine le profil des impulsions de contrôle.

Selon un mode de réalisation, le circuit de contrôle comprend un générateur de rampe pour conférer à une impulsion de contrôle un profil comprenant une rampe de tension.

Selon un mode de réalisation, les pilotes de ligne de mot comprennent chacun un interrupteur tire-bas dimensionné pour tirer rapidement au niveau bas, à la fin d'une impulsion de contrôle, une ligne de mot sélectionnée, en déchargeant une capacité parasite de la ligne de mot.

Selon un mode de réalisation, l'interrupteur tire-bas d'un pilote de ligne de mot est dimensionné pour tirer la ligne de mot à un niveau bas en quelques nanosecondes après que la ligne de mot a été polarisée avec une tension maximale que peut appliquer le pilote de ligne de mot.

Selon un mode de réalisation, le circuit intégré comprend un circuit de contrôle fournissant aux pilotes de ligne de mot un second signal de contrôle indiquant la fin d'une impulsion de contrôle.

Selon un mode de réalisation, le circuit intégré comprend un circuit de contrôle fournissant aux pilotes de ligne de mot un second signal de contrôle indiquant le début et la fin d'une impulsion de contrôle.

Selon un mode de réalisation, l'interrupteur tire-bas est contrôlé par le second signal de contrôle, de manière à tirer la ligne de mot au niveau bas lorsque le second signal de contrôle indique qu'une impulsion de contrôle est terminée.

Selon un mode de réalisation, les pilotes de ligne de mot sont agencés pour appliquer à une ligne de mot une impulsion de contrôle quand le décodeur de ligne de mot fournit un signal de sélection de la ligne de mot et quand le début d'une impulsion de contrôle est indiqué par le second signal de contrôle.

Selon un mode de réalisation, l'interrupteur tire-bas d'un pilote de ligne de mot est le transistor tire-bas d'une porte inverseuse comprenant un transistor tire-haut pour appliquer à la ligne de mot concernée une impulsion de contrôle.

Selon un mode de réalisation, l'entrée de la porte inverseuse est contrôlée par le second signal de contrôle, de manière à tirer la ligne de mot à un niveau bas lorsque le second signal de contrôle indique qu'une impulsion de contrôle est terminée.

Selon un mode de réalisation, l'entrée de la porte inverseuse est contrôlée par le second signal de contrôle et un signal de sélection de ligne de mot, de manière à : appliquer à la ligne de mot concernée une impulsion de contrôle lorsque le second signal de contrôle indique le début d'une impulsion et que le signal de sélection de ligne de mot indique que la ligne de mot est sélectionnée, et tirer la ligne de mot à un niveau bas lorsque le second signal de contrôle indique que l'impulsion de contrôle est terminée.

Selon un mode de réalisation, les pilotes de ligne de mot comprennent chacun un interrupteur tire-haut pour accélérer le passage à l'état haut de l'entrée de la porte inverseuse lorsque le second signal de contrôle indique qu'une impulsion de contrôle est terminée.

Selon un mode de réalisation, le circuit de contrôle comprend un interrupteur d'isolement agencé entre un noeud de sortie du circuit de contrôle et les pilotes de ligne de mot, et
- l'interrupteur d'isolement est ouvert par le circuit de contrôle à la fin d'une impulsion de contrôle, de manière à isoler le noeud de sortie du circuit de contrôle relativement aux pilotes de ligne de mot.

Selon un mode de réalisation, le point mémoire d'une cellule mémoire est un point mémoire à changement de phase.

Selon un mode de réalisation, le point mémoire d'une cellule mémoire est connecté à une ligne de bit par l'intermédiaire de laquelle il reçoit la tension ou le courant d'effacement ou de programmation, et est relié à un potentiel bas par l'intermédiaire du transistor de sélection de la cellule mémoire.

Selon un mode de réalisation, le transistor de sélection d'une cellule mémoire est un transistor MOS.

L'invention concerne également un procédé pour contrôler l'application d'impulsions de tension ou de courant d'effacement ou de programmation à des cellules mémoire comprenant chacune un point mémoire et un transistor de sélection ayant une borne de contrôle connectée à une ligne de mot, le procédé comprenant des étapes consistant à : appliquer une tension ou un courant d'effacement ou de programmation aux cellules mémoire, et appliquer à la ligne de mot les impulsions de contrôle dont le profil correspond à un profil d'impulsion de tension ou de courant d'effacement ou de programmation à appliquer à des points mémoire, afin de contrôler au moyen des transistors de sélection l'amplitude et la durée de la tension ou du courant d'effacement ou de programmation appliqué aux points mémoire.

Selon un mode de réalisation, le procédé comprend une étape consistant à contrôler le profil des impulsions de contrôle avec un générateur de rampe, pour conférer à des impulsions de contrôle un profil comprenant une rampe de tension.

Selon un mode de réalisation, le procédé comprend des étapes consistant à : prévoir un interrupteur tire-bas dimensionné pour tirer rapidement au niveau bas la ligne de mot à la fin d'une impulsion de contrôle, en déchargeant une capacité parasite de la ligne de mot, et mettre dans l'état passant l'interrupteur tire-bas à la fin d'une impulsion de contrôle.

Selon un mode de réalisation, l'interrupteur tire-bas est dimensionné pour tirer la ligne de mot à un niveau bas en quelques nanosecondes après que la ligne de mot a été polarisée avec une tension.

Selon un mode de réalisation, le procédé comprend des étapes consistant à : prévoir un pilote de ligne de mot pour appliquer les impulsions de contrôle à la ligne de mot, agencer l'interrupteur tire-bas dans le pilote de ligne de mot, et fournir au pilote de ligne de mot un signal de contrôle indiquant la fin d'une impulsion de contrôle et provoquant la fermeture de l'interrupteur tire-bas.

Selon un mode de réalisation, le procédé comprend une étape consistant à prévoir dans le pilote de ligne de mot une porte inverseuse comprenant le transistor tire-bas et un transistor tire-haut pour appliquer à la ligne de mot concernée les impulsions de contrôle.

Selon un mode de réalisation, le procédé comprend une étape consistant à contrôler l'entrée de la porte inverseuse au moyen du signal de contrôle et d'un signal de sélection de la ligne de mot, de manière à : appliquer à la ligne de mot une impulsion de contrôle lorsque le signal de contrôle indique le début d'une impulsion et que le signal de sélection indique que la ligne de mot est sélectionnée, et tirer la ligne de mot à un niveau bas lorsque le signal de contrôle indique que l'impulsion de contrôle est terminée.

Selon un mode de réalisation, le point mémoire d'une cellule mémoire est un point mémoire à changement de phase.

Selon un mode de réalisation, le transistor de sélection d'une cellule mémoire est un transistor MOS.

Ces objectifs, caractéristiques et avantages de l'invention ainsi que d'autres seront exposés plus en détail dans la description suivante d'exemples de réalisation d'une mémoire selon l'invention, faite à titre non limitatif en relation avec les figures jointes parmi lesquelles :
- la figure 1 précédemment décrite représente un plan mémoire comprenant des cellules mémoire à changement de phase,
- la figure 2 précédemment décrite représente un point mémoire à changement de phase dans l'état effacé et dans l'état programmé,
- les figures 3A et 3B précédemment décrites représentent respectivement une impulsion d'effacement et une impulsion de programmation appliquées à un point mémoire,
- la figure 4 précédemment décrite représente schématiquement une architecture classique de mémoire à changement de phase,
- la figure 5 représente schématiquement une architecture de mémoire à changement de phase selon l'invention,
- les figures 6A et 6B représentent respectivement une impulsion de contrôle d'effacement et une impulsion de contrôle de programmation selon l'invention,
- la figure 7 représente de façon plus détaillée un circuit de contrôle représenté sous forme de bloc sur la figure 5,
- les figures 8A à 8G représentent des signaux électriques apparaissant dans le circuit de contrôle pendant des périodes de programmation de cellules mémoire,
- les figures 9A à 9E représentent des signaux électriques apparaissant dans le circuit de contrôle pendant des périodes d'effacement de cellules mémoire,
- la figure 10 est le schéma électrique d'un générateur de rampe représenté sous forme de bloc sur la figure 7,
- les figures 11A à 11E représentent des signaux électriques apparaissant dans le générateur de rampe,
- la figure 12 est le schéma électrique d'un pilote de ligne de mot représenté sous forme de bloc sur les figures 5 et 7, et
- les figures 13A à 13E représentent des signaux électriques apparaissant dans le pilote de ligne de mot.

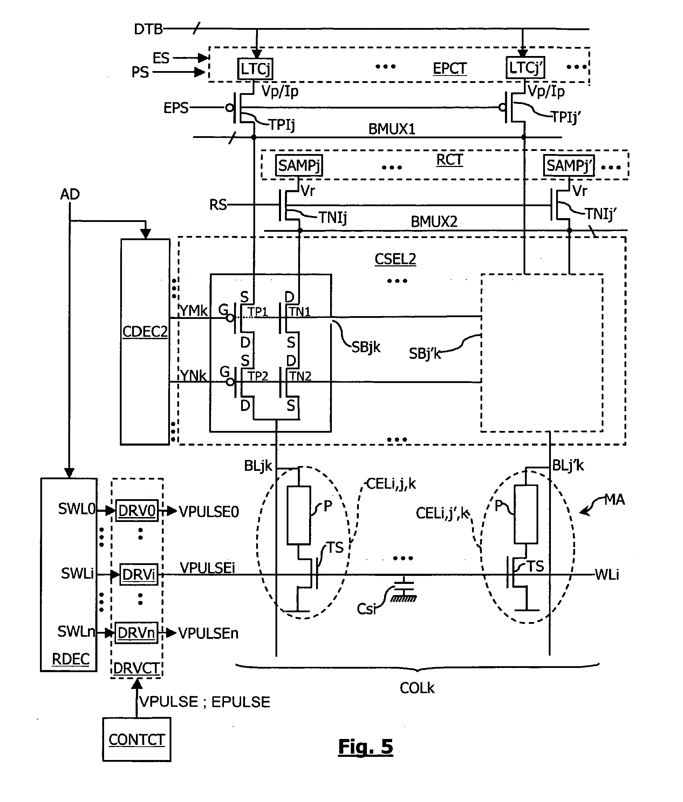

La figure 5 représente schématiquement une architecture de mémoire selon l'invention. La mémoire décrite ici à titre d'exemple de réalisation de l'invention est une mémoire effaçable et programmable par mot dans laquelle le nombre de bits par mot est défini par le nombre de lignes de bit que contient une colonne. Toutefois, comme cela sera précisé plus loin, et conformément aux règles usuelles d'architecture des mémoires, l'invention s'applique également à une mémoire effaçable et programmable par bit dans laquelle la notion de colonne n'est pas mise en oeuvre (c'est-à-dire dans laquelle une colonne correspond à une ligne de bit et une seule).

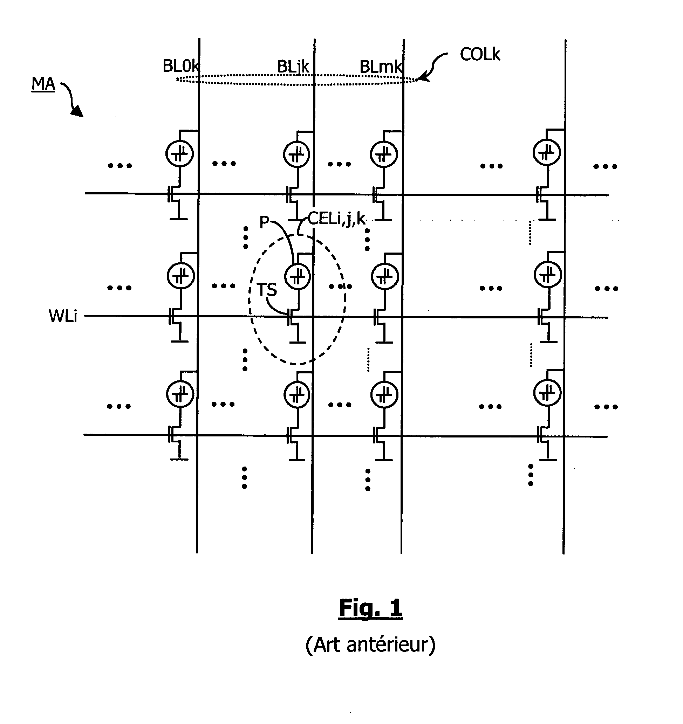

La mémoire comprend un plan mémoire MA de même type que celui représenté sur la figure 1. Dans un souci de lisibilité de la figure, ne sont représentés que les éléments suivants du plan mémoire :
- une ligne de mot WL de rang i (WLi),
- deux lignes de bit BL de rang j et j' (BLjk, BLj'k) appartenant à une colonne COL de rang k (COLk), chaque colonne comprenant m lignes de bit et définissant des mots de m bits (m étant égal à 1 dans le cas d'une mémoire effaçable et programmable par bit), et
- deux cellules mémoire CEL (CELi,j,k, CELi,j',k) connectées respectivement à la ligne de bit BLjk et à la ligne de bit BLj'k, et connectées toutes deux à la ligne de mot WLi, et
- divers éléments de rang i, j, j', ou k décrits plus loin, reliés à la ligne de mot WLi ou aux lignes de bit BLjk, BLj'k.

Chaque cellule mémoire du plan mémoire MA comprend un transistor de sélection TS et un point mémoire P à changement de phase. Le point mémoire P est relié par l'intermédiaire du transistor TS à un potentiel bas, ou à une ligne commutable à un potentiel bas, le potentiel bas étant préférentiellement la masse du circuit. Les transistors TS sont ici des transistors NMOS, mais des transistors bipolaires pourraient également être utilisés et de façon générale tout type d'interrupteur ayant une borne de commande autorisant un contrôle progressif de la conductivité de l'interrupteur.

La mémoire comprend également un décodeur de ligne RDEC, un décodeur de colonne CDEC2, un circuit CSEL2 de sélection de colonne, un circuit de lecture RCT et un circuit d'effacement ou programmation EPCT. Le décodeur RDEC et le décodeur CDEC2 reçoivent respectivement les bits de poids fort et de poids faible d'une adresse AD d'un mot mémoire à sélectionner (mot de 8 cellules mémoire ou plus selon le nombre de lignes de bit par colonne). Le décodeur RDEC fournit des signaux SWL (SWL0,...SWLi,....SwLn) de sélection des lignes de mot WL. Le décodeur CDEC2 fournit des signaux YM, YN de sélection de colonne à raison de deux signaux de sélection (YMk, YNk) par colonne de rang k (COLk).

Le circuit EPCT comprend des verrous d'effacement ou programmation LTC (LTCj, LTCj') qui fournissent chacun un signal d'effacement ou programmation Vp/Ip. L'effacement ou la programmation d'une cellule mémoire pouvant être fait classiquement en contrôlant la tension ou en contrôlant le courant appliqué à la cellule mémoire, le signal Vp/Ip peut présenter une tension Vp constante ou un courant Ip constant, selon qu'il est contrôlé en tension ou en courant.

Les verrous LTC reçoivent des données par l'intermédiaire d'un bus de données DTB à raison d'une donnée (bit) par verrou, et sont activés par un signal d'effacement ES et un signal de programmation PS distincts. Ainsi, un verrou LTC délivre lé signal d'effacement ou programmation Vp/Ip lorsque le signal d'effacement ES présente une valeur active (par exemple 1) et qu'il reçoit simultanément un bit à 0 sur une entrée de donnée. De même un verrou LTC délivre le signal d'effacement ou programmation Vp/Ip lorsque le signal de programmation PS présente une valeur active et qu'il reçoit simultanément un bit à 1 sur son entrée de donnée.

Le circuit de lecture RCT comprend des amplificateurs de lecture SAMP (SAMPj, SAMPj') fournissant une tension de lecture Vr de faible valeur, par exemple de l'ordre de 0,5 V comme indiqué plus haut.

Chaque verrou LTC (LTCj, LTCj') est relié à des lignes de bit par l'intermédiaire d'un transistor d'isolement TPI de type PMOS (TPIj , TPIj'), d'un bus de multiplexage BMUX1, et du circuit de sélection de colonne CSEL2. Chaque amplificateur de lecture SAMP (SAMPj, SAMPj') est relié à des lignes de bit par l'intermédiaire d'un transistor d'isolement TNI (TNIj, TNIj') de type NMOS, d'un bus de multiplexage BMUX2 et du circuit de sélection de colonne CSEL2.

Le circuit de sélection CSEL2 comprend un bloc de sélection SB (SBjk, SBj'k) pour chaque ligne de bit BL (BLjk, BLj'k). Les blocs de sélection de lignes de bit appartenant à une même colonne COLk (par exemple les blocs SBjk, SBj'k représentés) reçoivent les mêmes signaux de sélection YM, YN (par exemple les signaux représentés YMk, YNk).

Chaque bloc de sélection SB comprend ici deux sous-blocs de sélection PSB et NSB. Chaque sous-bloc NSB comprend ici deux transistors NMOS TN1, TN2 en série et chaque sous-bloc PSB comprend deux transistors PMOS TP1, TP2 en série. Les sous-blocs NSB, PSB d'un même bloc de sélection sont agencés en parallèle, le sous-bloc NSB reliant la ligne de bit concernée au verrou correspondant, et le sous-bloc NSB reliant la ligne de bit concernée à l'amplificateur de lecture correspondant. Les sous-blocs NSB, PSB d'un même bloc de sélection sont commandés ici par les mêmes signaux. Ainsi, les transistors TN1 et TP1 reçoivent le signal YM sur leur borne de grille et les transistors TN2 et TP2 reçoivent le signal YN sur leur borne de grille.

En résumé, chaque ligne de bit est reliée à un verrou d'effacement ou de programmation LTC fournissant un signal d'effacement ou programmation Vp/Ip de valeur fixe, par un chemin électrique ne comprenant que des transistors PMOS, ici les deux transistors d'un sous-bloc de sélection PSB et un transistor d'isolement TPI. De même, chaque ligne de bit est reliée à un amplificateur de lecture SAMP par un chemin électrique ne comprenant que des transistors NMOS, ici deux transistors d'un sous-bloc de sélection NSB et un transistor d'isolement TNI. Une telle architecture du circuit de sélection de colonne CSEL2, bien qu'optionnelle dans le cadre de la présente invention, permet de transférer le signal Vp/Ip jusqu'aux lignes de bit sélectionnées sans perte de tension dans les divers transistors, et en n'appliquant que des signaux basse tension aux bornes de grille de ces transistors.

Selon l'invention, les verrous LTC ne fournissent pas les impulsions d'effacement RPULSE ou de programmation SPULSE décrites plus haut. Les verrous fournissent simplement un signal Vp/Ip de valeur fixe et la modulation de ce signal est faite au moyen des transistors TS des cellules mémoire, d'une manière décrite plus loin. Il en résulte que la structure des verrous est d'une grande simplicité. Ces verrous sont de simples commutateurs de tension ou de courant d'un type en soi connu et sont par exemple utilisés dans l'art antérieur pour appliquer une haute tension de programmation Vpp aux lignes de bit dans les mémoires EEPROM ou FLASH comportant des transistors à grille flottante. De plus, si le signal d'effacement ou programmation Vp/Ip est contrôlé en tension, la tension Vp que doivent fournir les verrous est ici une tension de l'ordre de 6 Volt, bien inférieure à la tension Vpp des mémoires EEPROM ou FLASH qui est de l'ordre de 10 à 15 V. Des transistors haute tension ne sont donc même pas nécessaires pour réaliser les verrous.

D'autre part, si l'on choisit de réaliser une mémoire effaçable et programmable par bit, ces verrous ne sont aucunement nécessaires. Dans ce cas, le signal d'effacement ou programmation Vp/Ip est appliqué simultanément à tous les transistors d'isolement TPI au moyen d'un commutateur unique pour l'ensemble du plan mémoire.

On décrira maintenant des moyens selon l'invention permettant d'appliquer aux cellules mémoire les impulsions d'effacement ou programmation RPULSE et SPULSE représentées sur les figures 3A, 3B, pendant que les verrous LTC fournissent un signal d'effacement ou programmation Vp/Ip de valeur constante, ou pendant que tous les transistors d'isolement TPI reçoivent simultanément le signal Vp/Ip (dans le cas d'une mémoire effaçable et programmable par bit).

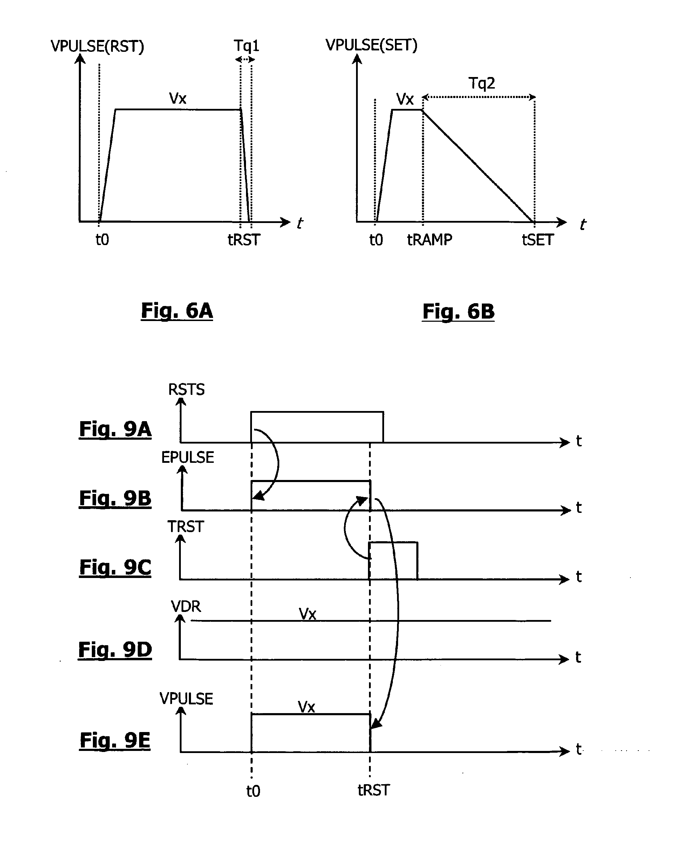

Selon l'invention, une ligne de mot WL sélectionnée en effacement ou programmation, par exemple la ligne WLi représentée, reçoit des impulsions de contrôle VPULSE (VPULSEi) égales à VPULSE(RST) ou à VPULSE(SET), qui pilotent les bornes de grille des transistors TS de sélection des cellules mémoire connectées à cette ligne de mot. Ces impulsions de contrôle agissent sur la conductivité des transistors TS et permettent de moduler la tension ou le courant qui traverse les points mémoires P. La forme de ces impulsions de contrôle est représentée schématiquement sur les figures 6A, 6B.

L'impulsion de contrôle VPULSE(RST) représenté sur la figure 6A est une impulsion de tension de valeur Vx, de profil sensiblement similaire à celui de l'impulsion RPULSE représentée sur la figure 3A. Cette impulsion est utilisée pour commander les transistors de sélection TS pendant une phase d'effacement de cellules mémoire. Elle présente notamment une durée tRST identique à la durée souhaitée du signal RPULSE, et est suivie d'un front descendant très raide de durée Tq1 de l'ordre de quelques nanosecondes.

De même, l'impulsion de contrôle VPULSE(SET) représentée sur la figure 6B est une impulsion de tension de profil sensiblement similaire à celui du signal SPULSE représenté sur la figure 3B et est utilisée pour commander les transistors de sélection TS pendant une phase de programmation de cellules mémoire. Cette impulsion de durée tSET présente un plateau de valeur Vx et de durée tRAMP de l'ordre de 50 nanosecondes, suivi d'un front descendant à faible pente allant de Vx à zéro, d'une durée Tq2 égale à tSET-tRAMP, par exemple 300 nanosecondes.

A cet effet, et comme cela est représenté en figure 5, un circuit pilote DRVCT ("Driver Circuit") est interposé entre le décodeur de ligne RDEC et le plan mémoire MA. Le circuit DRVCT comprend des pilotes de ligne de mot DRV ("world line drivers") à raison d'un pilote par ligne de mot. Ces pilotes sont référencés DRV0,...DRVi,...DRVn sur la figure 5 en supposant que le plan mémoire comprend n+1 ligne de mot WL. Ils reçoivent chacun un signal de contrôle VPULSE fourni par un circuit de contrôle CONTCT et sont agencés entre le décodeur de ligne de mot RDEC et la ligne de mot à laquelle ils sont affectés. Le décodeur RDEC leur applique les signaux de sélection SWL (SWL0,...SWLi,...SWLn) au lieu d'appliquer ces signaux aux lignes dé mot.

Selon un aspect optionnel mais avantageux de l'invention, le circuit CONTCT fournit également aux pilotes DRV un signal de synchronisation EPULSE permettant à ceux-ci de connaître l'instant où une impulsion de contrôle VPULSE(RST) ou VPULSE(SET) se termine. Comme cela sera vu plus loin, ce signal de synchronisation permet notamment aux pilotes de ligne de mot de tirer eux-mêmes au potentiel bas (ici la masse) les lignes de mot ayant reçu la tension Vx, en déchargeant rapidement des capacités parasites Cs (Csi) présentes sur ces lignes de mot. En d'autres termes, la mise à 0 des lignes de mot est assurée par les pilotes eux-mêmes, plutôt que par le circuit CONTCT, et permet d'obtenir un front de descente Tq1 très raide au terme de l'impulsion VPULSE(RST).

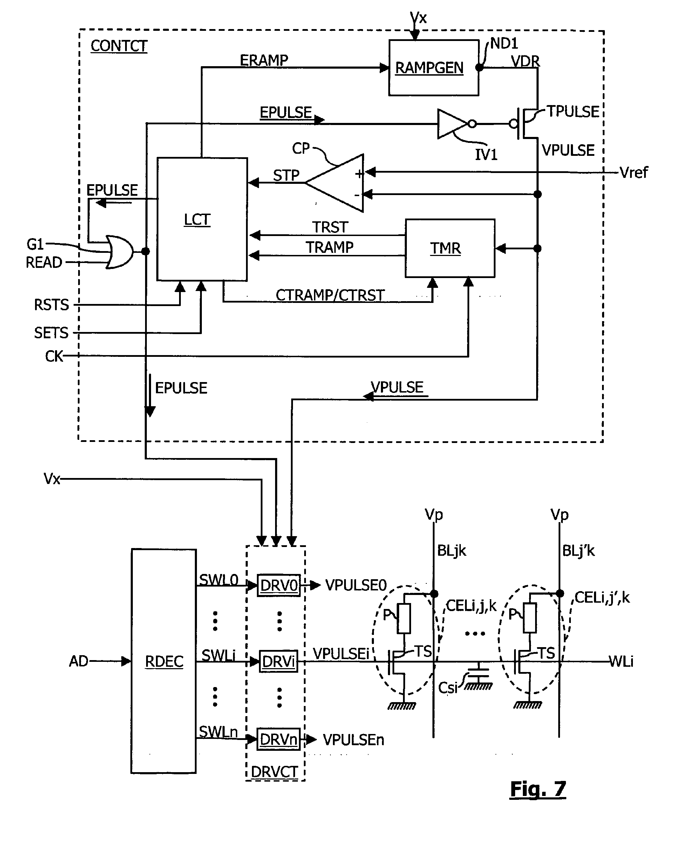

La figure 7 représente un exemple de réalisation du circuit CONTCT. Celui-ci comprend un circuit logique de contrôle LCT, une porte G1 de type "OU", une porte inverseuse IV1, un générateur de rampe RAMPGEN alimenté électriquement par la tension Vx, une minuterie TMR ("timer") cadencée par un signal d'horloge CK, un comparateur CP et, optionnellement, un transistor de sortie TPULSE, ici de type PMOS. Le transistor TPULSE a sa borne de source connectée à un noeud de sortie ND1 du générateur RAMPGEN, et sa borne de drain fournit le signal de contrôle VPULSE.

Le circuit LCT reçoit deux signaux de commandes externes RSTS et SETS indiquant respectivement qu'une impulsion d'effacement VPULSE(RST) ou de programmation VPULSE (SET) doit être appliquée à des lignes de mot. Sur réception de l'une de ces commandes, le circuit LCT fournit le signal EPULSE ("Enable Pulse") qui est ici égal à 1 pendant toute la durée de l'impulsion. Le signal EPULSE est envoyé aux pilotes DRV par l'intermédiaire de la porte G1, qui reçoit sur une autre entrée un signal READ. Ce signal READ permet de forcer le signal EPULSE à 1 pendant des phases de lecture, afin de forcer les pilotes dans l'état passant pendant la lecture de cellules mémoire. Le signal EPULSE est également appliqué au générateur RAMPGEN et est appliqué à la borne de grille du transistor TPULSE par l'intermédiaire de la porte inverseuse IV1, de sorte que le transistor TPULSE devient passant quand le signal EPULSE est égal à 1.

Le générateur RAMPGEN fournit sur le noeud de sortie ND1 une tension VDR qui est égale à la tension Vx tant que le circuit LCT ne met pas à 1 un signal ERAMP ("Enable Ramp"). Lorsque le signal ERAMP passe à 1, la tension VDR décroît et tend vers 0 avec une pente qui est réglée de manière que le passage de Vx à 0 corresponde sensiblement au temps d'extinction Tq2 d'une impulsion SPULSE (fig. 3B) soit la différence entre l'instant tSET et l'instant tRAMP (fig. 3B et 6B).

Le comparateur CP reçoit une tension de référence Vref sur une entrée positive et son entrée négative est connectée au noeud ND1 ou à la borne de drain du transistor TPULSE. Il fournit au circuit LCT un signal d'arrêt d'impulsion STP lorsque le niveau de la tension VDR devient inférieur à Vref.

La minuterie TMR détermine les instants tRAMP et tRST, soit respectivement l'instant où une rampe de tension descendante doit être produite par le circuit PULSCT après le commencement de l'impulsion VPULSE(SET), et l'instant où une impulsion VPULSE(RST) doit se terminer. A cet effet la minuterie reçoit du circuit LCT deux signaux CTRAMP et CTRST lui indiquant quel est celui des deux délais qui doit être calculé. L'activation de la minuterie est déclenchée par le signal VPULSE, lorsque celui-ci passe de 0 à la tension Vx sur la borne de drain du transistor TPULSE. Lorsque l'instant tRAMP est atteint la minuterie fournit au circuit LCT un signal TRAMP égal à 1. Lorsque l'instant tRST est atteint la minuterie fournit au circuit LCT un signal TRST égal à 1.

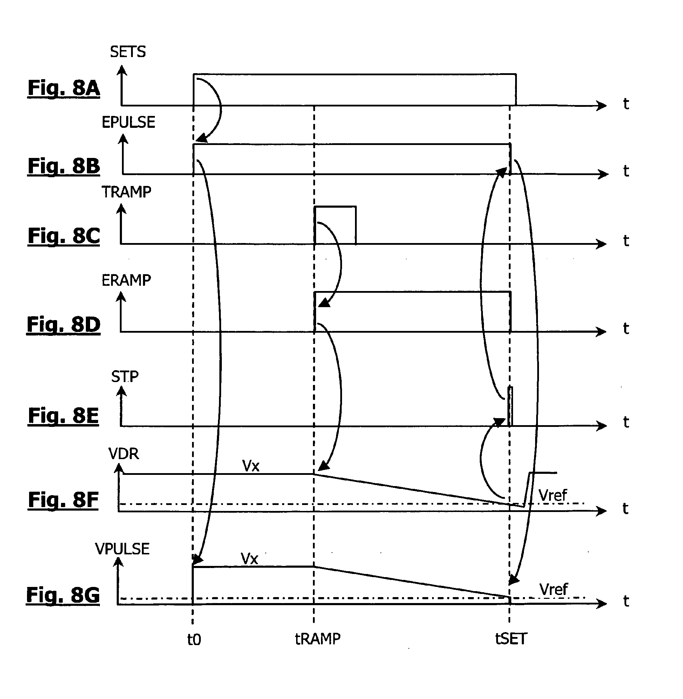

Le fonctionnement du circuit CONTCT en réponse au signal SETS est illustré par les figures 8A à 8G qui représentent respectivement les signaux SETS, EPULSE, TRAMP, ERAMP, STP, la tension VDR et le signal VPULSE. A un instant t0 le signal SETS est mis à 1 (fig. 8A) et le circuit LCT met le signal EPULSE à 1 (fig. 8B). Le transistor TPULSE devient passant et le signal VPULSE devient égal à VDR soit égal à la tension Vx (fig. 8G), car la tension VDR a été préalablement stabilisée (fig. 8F) en appliquant la tension Vx au générateur RAMPGEN. A l'instant tRAMP la minuterie TMR met le signal TRAMP à 1 (fig. 8C) et le circuit LCT met le signal ERAMP à 1 (fig. 8D). La tension VDR et le signal VPULSE commencent à décroître (fig. 8F et 8G). A l'instant tSET le niveau de la tension VDR ainsi que celui du signal VPULSE deviennent sensiblement inférieurs à Vref (fig. 8G) et le comparateur CP met à 1 le signal d'arrêt STP (fig. 8E). Le circuit LCT met alors à 0 le signal EPULSE (fig. 8B) et le transistor TPULSE se bloque, de sorte que sa borne de drain passe dans l'état haut impédance. De façon quasi-simultanée, au temps de réaction près du générateur RAMPGEN, la tension VDR remonte au niveau de tension Vx, de sorte que le noeud de sortie ND1 se retrouve préchargé et prêt à fournir de nouveau la tension Vx.

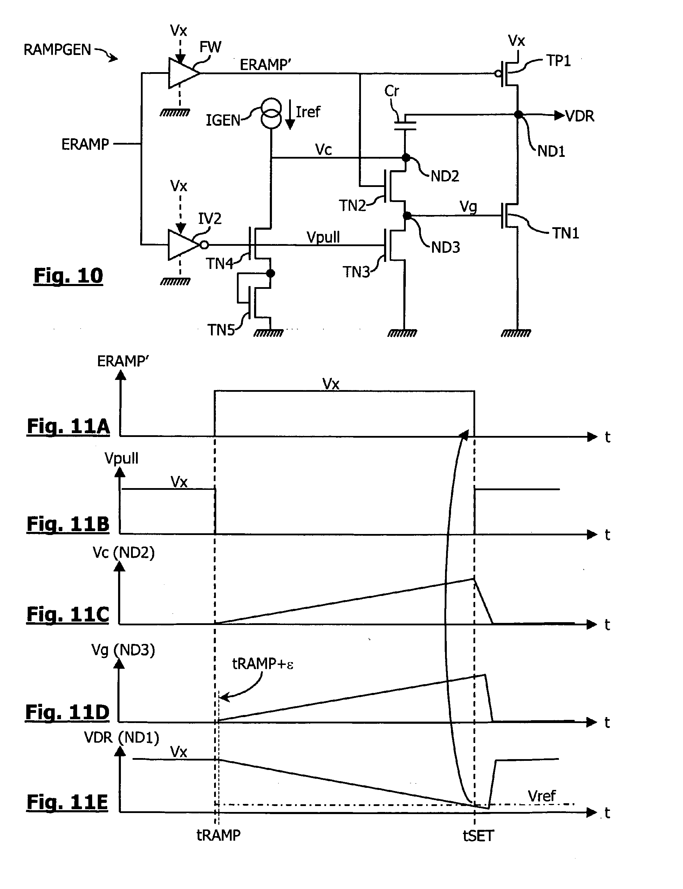

Le fonctionnement du circuit CONTCT en réponse au signal RSTS est illustré par les figures 9A à 9E (sous les figures 6A, 6B) qui représentent respectivement les signaux RSTS, EPULSE, TRST, la tension VDR et le signal VPULSE. A un instant t0 le signal RSTS est mis à 1 (fig. 9A) et le circuit LCT met le signal EPULSE à 1 (fig. 9B). Le transistor TPULSE devient passant et le signal VPULSE devient égal à VDR soit égal à la tension Vx (fig. 9E), car la tension VDR a été préalablement stabilisée (fig. 9D) en appliquant la tension Vx au générateur RAMPGEN. A l'instant tRST la minuterie TMR met le signal TRST à 1 (fig. 9C) et le circuit LCT met alors à 0 le signal EPULSE (fig. 9B). Le transistor TPULSE se bloque, de sorte que le drain de ce transistor passe dans l'état haut impédance. La tension VDR reste égale à Vx, de sorte que le noeud de sortie ND1 du générateur reste préchargé pour fournir de nouveau la tension Vx.

Comme évoqué plus haut, le temps d'extinction très court Tq1 de l'impulsion VPULSE(RST) (fig. 6A) n'est pas contrôlé par le circuit CONTCT dont la sortie passe ici à haute impédance, et ce contrôle est assuré localement par les pilotes de ligne de mot DRV, d'une manière qui sera décrite plus loin.

La figure 10 représente un exemple de réalisation du générateur de rampe RAMPGEN. Celui-ci comprend un transistor TP1 de type PMOS, des transistors TN1, TN2, TN3, TN4, TN5 de type NMOS, un suiveur FW et une porte inverseuse IV2 alimentés électriquement par la tension Vx, un générateur de courant IGEN fournissant un courant Iref et un condensateur de rampe Cr. La borne de source du transistor TP1 reçoit la tension Vx, la borne de drain de ce transistor est connectée à celle du transistor TN1 en un point formant le noeud de sortie ND1 du générateur, fournissant la tension VDR. La borne de source du transistor TN1 est connectée à la masse. L'anode du condensateur Cr est connectée au noeud ND1, et la cathode du condensateur Cr est connectée à la borne de drain du transistor TN2, en un noeud ND2 de tension Vc. La borne de source du transistor TN2 est connectée à la borne de drain du transistor TN3 en un noeud ND3 de tension Vg, la borne de source du transistor TN3 étant connectée à la masse. La borne de drain du transistor TN4 est connectée à la sortie du générateur de courant IGEN et au noeud ND2. La borne de source de ce transistor est connectée à la borne de drain du transistor TN5 dont la borne de source est connectée à la masse. Le transistor TN5 a par ailleurs sa borne de grille connectée à sa borne de drain (montage en diode).

Le signal ERAMP est appliqué aux bornes de grille des transistors TP1, TN2 par l'intermédiaire du suiveur FW, qui fournit un signal ERAMP' de tension 0 ou Vx (1 logique). Le signal ERAMP est également appliqué à la porte IV2 qui fournit un signal Vpull dont le niveau de tension est 0 ou Vx selon la valeur logique du signal ERAMP. Le signal Vpull est appliqué aux bornes de grille des transistors TN4 et TN3. Enfin, la borne de grille du transistor TN1 est contrôlée par le noeud ND3.

Le fonctionnement du générateur RAMPGEN entre les instants tRAMP et tSET est illustré sur les figures 11A à 11E qui représentent respectivement le signal ERAMP', le signal Vpull, la tension Vc (noeud ND2), la tension Vg (noeud ND3) et la tension de sortie VDR (noeud ND1) . Avant l'instant tRAMP, le signal ERAMP' est à 0 est le signal Vpull est à 1 (Vx). Le transistor TP1 est passant et la tension de sortie VDR est égale à Vx. Le condensateur Cr est chargé, les transistors TN4 et TN5 sont passants et le noeud ND2 (tension Vc) est relié à la masse. Lorsque le signal ERAMP passe à 1, le signal ERAMP' passe à 1 et le signal Vpull passe à 0. Les transistors TP1, TN3 et TN4 se bloquent, le transistor TN2 devient passant et le noeud ND2 (tension Vc) commence à se charger avec un courant imposé par le générateur de courant IGEN. Lorsque la rampe de tension apparaissant sur le noeud ND2 atteint la tension de seuil du transistor TN1, à un instant tRAMP+ε, le transistor TN2 recopie la rampe de tension sur le noeud ND3 et le transistor TN1 devient progressivement passant, de sorte que le condensateur Cr se décharge progressivement. La tension de sortie VDR commence à diminuer de façon inversement proportionnelle à la rampe de tension sur le noeud ND2, et forme une rampe de tension décroissante. Lorsque la tension VDR (recopiée par le signal VPULSE) devient égale à Vref et que le circuit LCT remet à 0 le signal ERAMP, le signal ERAMP' repasse à 0 et le transistor TP1 redevient passant, de sorte que la tension de sortie VDR redevient égale à Vx.

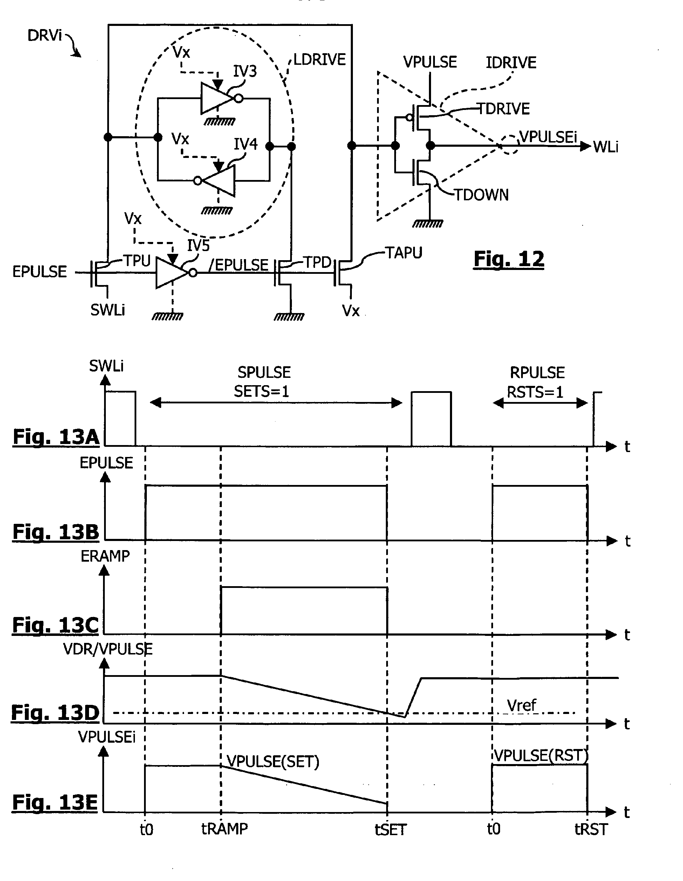

La figure 12 représente un exemple de réalisation d'un pilote de ligne de mot DRV, par exemple le pilote DRVi de la ligne de mot WLi représentée sur les figures 5 et 7, tous les pilotes de ligne de mot étant de même structure. Le pilote DRVi fournit une impulsion de contrôle VPULSEi à la ligne de mot WLi sur réception du signal de contrôle VPULSE et du signal EPULSE fournis par le circuit CONTCT.

Le pilote DRVi comprend des portes inverseuses IV3, IV4, IV5 alimentées électriquement par la tension Vx, une porte inverseuse de sortie IDRIVE, trois transistors NMOS dont un transistor tire-haut TPU ("pull-up"), un transistor tire-bas TPD ("pull-down"), et un autre transistor tire-haut TAPU. La porte IDRIVE est formée par un transistor TDRIVE de type PMOS et un transistor TDOWN de type NMOS en série, les deux transistors ayant leurs bornes de grille interconnectées. Le transistor TDRIVE reçoit le signal de contrôle VPULSE sur sa borne de drain. Sa borne de drain est reliée à la borne de drain du transistor TDOWN dont la borne de source est connectée à la masse.

Les portes IV3, et IV4 sont connectées tête-bêche pour former un verrou LDRIVE (point mémoire volatile). L'entrée de ce verrou est reliée à l'entrée de la porte inverseuse IDRIVE ainsi qu'à la borne de drain du transistor TPU et à la borne de drain du transistor TAPU. La sortie du verrou est connectée à la borne de drain du transistor TPD. La borne de source du transistor TPD est connectée à la masse et la borne de source du transistor TAPU reçoit la tension Vx. Le transistor TPU reçoit le signal de sélection de ligne de mot SWLi sur sa borne de source (fourni par le décodeur CDEC, Cf. fig. 5 ou 7) et reçoit sur sa borne de grille le signal EPULSE. Les transistors TPD et TAPU reçoivent sur leurs bornes de grille le signal inversé /EPULSE fourni par la porte IV5.

La sélection de la ligne de mot SWLi est assurée par le décodeur CDEC qui met le signal SWLi à 0. Lorsque le signal EPULSE est émis (i.e. passe à 1), le transistor TPU devient passant et force à 0 l'entrée du verrou LDRIVE et par conséquent l'entrée de la porte IDRIVE. Le transistor TDRIVE devient passant et applique à la ligne de mot le signal de contrôle VPULSE. Lorsque le signal EPULSE repasse à 0, le signal /EPULSE passe à 1 et les transistors TPD et TAPU sont passants. Le transistor TPD met à 0 la sortie du verrou LDRIVE dont l'entrée bascule ainsi à 1. Simultanément, le transistor TAPU ("Accelerated Pull Up Transistor") force à 1 (soit la tension Vx) l'entrée de la porte IDRIVE pour accélérer son basculement, sans attendre que l'état de la sortie du verrou ait provoqué le basculement de son entrée. La porte IDRIVE passe ainsi à 0 très rapidement, y compris lorsque la tension Vx vient d'être appliquée à la ligne de mot. Ainsi, le transistor TDOWN devient passant très rapidement et tire à 0 la ligne de mot WLi, en déchargeant rapidement la capacité parasite de la ligne de mot. A cet effet, le transistor TDOWN présente un rapport largeur sur longueur de grille (W/L) qui est choisi en fonction de l'importance de la capacité parasite de la ligne de mot, laquelle dépend de la longueur de la ligne de mot et du nombre de transistors de sélection TS qui y est connecté (les capacités parasites grille-source des transistors TS s'additionnant à la capacité parasite intrinsèque de la ligne de mot).

Il sera noté que, dans le présent mode de réalisation, le pilote DRVi est contrôlé par le signal EPULSE qui marque à la fois le début d'une impulsion de contrôle VPULSEi (en rendant le transistor TDRIVE passant) et la fin d'une impulsion (en bloquant le transistor TDRIVE et en rendant simultanément le transistor TDOWN passant). Dans ces conditions, le transistor TPULSE du circuit CONTCT, décrit plus haut en relation avec la figure 7, n'est pas nécessaire puisque le début et la fin d'une impulsion VPULSEi sur la ligne de mot WLi sont contrôlés par le transistor TDRIVE. Si le transistor TPULSE est supprimé, le signal VPULSE est identique à la tension VDR fournie par le générateur RAMPGEN et n'est plus un signal de contrôle pulsé.

Le fonctionnement du pilote DRVi est illustré plus en détail sur les figures 13A à 13E dans le cas précité où le signal VPULSE est identique à la tension VDR. Les figures 13A à 13E représentent respectivement le signal de sélection SWLi, le signal EPULSE, le signal ERAMP, le signal VDR/VPULSE, et l'impulsion de contrôle VPULSEi. La partie gauche de ces figures illustre l'application d'une impulsion de programmation SPULSE à des cellules mémoire et la partie droite des figures illustre l'application d'une impulsion d'effacement RPULSE, soit respectivement l'application d'une impulsion VPULSE(SET) et d'une impulsion VPULSE(RST) aux transistors de sélection TS. Les signaux illustrés diffèrent seulement de ceux décrits plus haut par le fait que le signal VPULSE n'est pas contrôlé temporellement par le signal EPULSE et que la délimitation temporelle des impulsions de contrôle (début et fin des impulsions) ne se retrouve que sur le signal VPULSEi (effet du transistor TDRIVE), tant pour l'impulsion VPULSE(SET) que l'impulsion VPULSE(RST).

Il apparaîtra clairement à l'homme de l'art que la présente invention est susceptible de diverses variantes de réalisation, notamment en ce qui concerne les pilotes DRV et le circuit de contrôle CONTCT. En particulier, il découle des observations qui précèdent que les pilotes de ligne de mot peuvent ne pas être contrôlés par le signal EPULSE qui marque le début et la fin d'une impulsion VPULSE(RST) ou VPULSE(SET), et n'être contrôlés que par les signaux de sélection SWL (SWL0-SWLn). Dans ce cas le transistor TPULSE (ou tout moyen équivalent) doit être conservé dans le circuit CONTCT pour contrôler le début et la fin des impulsions VPULSE et le signal de contrôle VPULSE est un signal pulsé. Les pilotes reçoivent seulement, en sus du signal pulsé, un signal qui indique la fin des impulsions et qui est appliqué collectivement à tous les pilotes pour rendre le transistor TDOWN passant et tirer rapidement à 0 les lignes de mot ayant reçu la tension Vx.

Egalement, le circuit CONTCT peut être scindé en deux circuits de contrôle distincts, l'un étant équipé du générateur de rampe et assurant le contrôle du profil des impulsions de contrôle, l'autre étant équipé de la minuterie et du comparateur de tension et assurant le contrôle de la durée des impulsions de contrôle. La fonction du comparateur (détermination de la fin des impulsions VPULSE(SET)) peut également être assurée par la minuterie si la pente de la rampe de tension est stable avec le vieillissement du circuit intégré ou en fonction de la température.

Est également susceptible de modifications la forme précise des impulsions RPULSE et SPULSE représentées sur les figures 3A, 3B et la forme correspondante des impulsions de contrôle VPULSE(RST) et VPULSE(SET) représentées sur les figures 3A, 6B. En particulier l'impulsion SPULSE et l'impulsion de contrôle correspondante VPULSE(SET) peuvent ne pas comprendre le temps de plateau allant de t0 à tRAMP. Ces impulsions sont alors formées uniquement par une rampe décroissante. Dans le circuit CONTCT représenté sur la figure 7, le signal ERAMP est alors émis au même instant que le signal EPULSE et il n'est plus nécessaire que la minuterie TMR fournisse le signal TRAMP.

Comme cela a été souligné dans ce qui précède, le plan mémoire peut être du type effaçable et programmable par bit. Dans un tel mode de réalisation, l'effacement ou la programmation des cellules mémoire s'effectue de façon individuelle et séquentielle (l'une après l'autre). Une écriture par bit peut être préférée à une écriture par mot selon les contraintes technologiques intervenant dans la conception de la mémoire, notamment pour éviter de devoir collecter un courant résultant important égal à la somme des courants d'effacement et de programmation traversant chacune des cellules mémoire concernées lors de l'écriture collective de toutes les cellules mémoire d'un mot.

Il apparaîtra également à l'homme de l'art que la présente invention est susceptible de diverses applications et n'est pas limitée aux mémoires à changement de phase. Bien que l'invention ait été initialement conçue pour répondre au problème technique exposé au préambule, les avantages de l'invention peuvent être recherchés avec d'autres types de cellules mémoire, ces avantages étant essentiellement de moduler une tension ou un courant de ligne de bit au moyen des lignes de mot, et pouvoir appliquer à des cellules mémoire des signaux de tension ou de courant de forme complexe, dont certains peuvent présenter un temps d'extinction très court.

La présente invention concerne de façon générale tout type de circuit intégré comprenant une mémoire, depuis les mémoires commercialisées sous forme de circuits intégrés jusqu'aux circuits intégrés complexes comprenant une mémoire et divers autres éléments utilisant la mémoire, par exemple des microcontrôleurs.

## Revendications

1. Circuit intégré comprenant une mémoire non-volatile comportant :
- des cellules mémoire (CEL) comprenant chacune un point mémoire (P) et un transistor de sélection (TS) ayant une borne de contrôle connectée à une ligne de mot (WL),
- un décodeur de ligne (RDEC) pour fournir des signaux (SWL) de sélection de lignes de mot, et
- au moins un générateur de tension ou courant (LTC) pour fournir à des cellules mémoire une tension (Vp) ou un courant (Ip) d'effacement ou de programmation,
**caractérisé en ce qu'**il comprend des pilotes de ligne de mot (DRV) interposés entre le décodeur de ligne (RDEC) et les lignes de mot (wL), agencés pour appliquer à une ligne de mot sélectionnée par le décodeur de ligne des impulsions de contrôle (VPULSEi) dont le profil correspond à un profil d'impulsion de tension ou de courant d'effacement ou de programmation à appliquer à des points mémoire, et contrôler ainsi au moyen des transistors de sélection (TS) l'amplitude et la durée de la tension ou du courant d'effacement ou de programmation appliqué aux points mémoire.

2. Circuit intégré selon la revendication 1, comprenant un circuit de contrôle (CONTCT) fournissant aux pilotes de ligne de mot (DRV) un premier signal de contrôle (VPULSE) dont le profil détermine le profil des impulsions de contrôle (VPULSEi).

3. Circuit intégré selon la revendication 2, dans lequel le circuit de contrôle (CONTCT) comprend un générateur de rampe (RAMPGEN) pour conférer à une impulsion de contrôle (VPULSEi) un profil comprenant une rampe de tension.

4. Circuit intégré selon l'une des revendications 1 à 3, dans lequel les pilotes de ligne de mot (DRV) comprennent chacun un interrupteur tire-bas (TDOWN) dimensionné pour tirer rapidement au niveau bas, à la fin d'une impulsion de contrôle (VPULSEi), une ligne de mot sélectionnée (WL), en déchargeant une capacité parasite (Cs) de la ligne de mot.

5. Circuit intégré selon la revendication 4, dans lequel l'interrupteur tire-bas (TDOWN) d'un pilote de ligne de mot est dimensionné pour tirer la ligne de mot à un niveau bas en quelques nanosecondes après que la ligne de mot a été polarisée avec une tension maximale (Vx) que peut appliquer le pilote de ligne de mot.

6. Circuit intégré selon l'une des revendications 4 et 5, comprenant un circuit de contrôle (CONTCT) fournissant aux pilotes de ligne de mot (DRV) un second signal de contrôle (EPULSE) indiquant la fin d'une impulsion de contrôle (VPULSEi).

7. Circuit intégré selon l'une des revendications 4 à 6, comprenant un circuit de contrôle (CONTCT) fournissant aux pilotes de ligne de mot (DRV) un second signal de contrôle (EPULSE) indiquant le début et la fin d'une impulsion de contrôle (VPULSEi).

8. Circuit intégré selon l'une des revendications 6 et 7, dans lequel l'interrupteur tire-bas (TDOWN) est contrôlé par le second signal de contrôle (EPULSE), de manière à tirer la ligne de mot au niveau bas lorsque le second signal de contrôle (EPULSE) indique qu'une impulsion de contrôle (VPULSEi) est terminée.

9. Circuit intégré selon la revendication. 7, dans lequel les pilotes de ligne de mot (DRV) sont agencés pour appliquer à une ligne de mot (WL) une impulsion de contrôle (VPULSEi) quand le décodeur de ligne de mot fournit un signal (SWL) de sélection de la ligne de mot (WL) et quand le début d'une impulsion de contrôle (VPULSEi) est indiqué par le second signal de contrôle (EPULSE).

10. Circuit intégré selon l'une des revendications 6 à 9, dans lequel l'interrupteur tire-bas (TDOWN) d'un pilote de ligne de mot (DRV) est le transistor tire-bas d'une porte inverseuse (IDRIVE) comprenant un transistor tire-haut (TDRIVE) pour appliquer à la ligne de mot concernée une impulsion de contrôle (VPULSEi).

11. Circuit intégré selon la revendication 10, dans lequel l'entrée de la porte inverseuse (IDRIVE) est contrôlée par le second signal de contrôle (EPULSE), de manière à tirer la ligne de mot à un niveau bas lorsque le second signal de contrôle (EPULSE) indique qu'une impulsion de contrôle (VPULSEi) est terminée.

12. Circuit intégré selon les revendications 7 et 10, dans lequel l'entrée de la porte inverseuse (IDRIVE) est contrôlée par le second signal de contrôle (EPULSE) et un signal de sélection (SWL) de ligne de mot, de manière à :
- appliquer à la ligne de mot concernée une impulsion de contrôle (VPULSEi) lorsque le second signal de contrôle (EPULSE) indique le début d'une impulsion et que le signal de sélection de ligne de mot (SWL) indique que la ligne de mot est sélectionnée, et
- tirer la ligne de mot à un niveau bas lorsque le second signal de contrôle (EPULSE) indique que l'impulsion de contrôle (VPULSEi) est terminée.

13. Circuit intégré selon l'une des revendications 10 à 12, dans lequel les pilotes de ligne de mot (DRV) comprennent chacun un interrupteur tire-haut (TAPU) pour accélérer le passage à l'état haut de l'entrée de la porte inverseuse (IDRIVE) lorsque le second signal de contrôle (EPULSE) indique qu'une impulsion de contrôle (VPULSEi) est terminée.

14. Circuit intégré selon l'une des revendications 6 à 13, dans lequel :
- le circuit de contrôle (CONTCT) comprend un interrupteur d'isolement (TPULSE) agencé entre un noeud de sortie (ND1) du circuit de contrôle et les pilotes de ligne de mot (DRV), et
- l'interrupteur d'isolement (TPULSE) est ouvert par le circuit de contrôle à la fin d'une impulsion de contrôle (VPULSEi), de manière à isoler le noeud de sortie (ND1) du circuit de contrôle relativement aux pilotes de ligne de mot.

15. Circuit intégré selon l'une des revendications 1 à 14, dans lequel le point mémoire (P) d'une cellule mémoire est un point mémoire à changement de phase.

16. Circuit intégré selon l'une des revendications 1 à 15, dans lequel le point mémoire d'une cellule mémoire est connecté à une ligne de bit (BL) par l'intermédiaire de laquelle il reçoit la tension ou de courant d'effacement ou de programmation, et est relié à un potentiel bas par l'intermédiaire du transistor (TS) de sélection de la cellule mémoire.

17. Circuit intégré selon l'une des revendications 1 à 16, dans lequel le transistor de sélection (TS) d'une cellule mémoire est un transistor MOS.

18. Procédé pour contrôler l'application d'impulsions de tension ou de courant d'effacement ou de programmation à des cellules mémoire (CEL) comprenant chacune un point mémoire (P) et un transistor de sélection (TS) ayant une borne de contrôle connectée à une ligne de mot (WL), **caractérisé en ce qu'**il comprend des étapes consistant à :
- appliquer une tension (Vp) ou un courant (Ip) d'effacement ou de programmation aux cellules mémoire, et
- appliquer à la ligne de mot les impulsions de contrôle (VPULSEi) dont le profil correspond à un profil d'impulsion de tension ou de courant d'effacement ou de programmation à appliquer à des points mémoire, afin de contrôler au moyen des transistors de sélection (TS) l'amplitude et la durée de la tension ou du courant d'effacement ou de programmation appliqué aux points mémoire.

19. Procédé selon la revendication 18, comprenant une étape consistant à contrôler le profil des impulsions de contrôle (VPULSEi) avec un générateur de rampe (RAMPGEN), pour conférer à des impulsions de contrôle un profil comprenant une rampe de tension.

20. Procédé selon l'une des revendications 18 et 19, comprenant des étapes consistant à :
- prévoir un interrupteur tire-bas (TDOWN) dimensionné pour tirer rapidement au niveau bas la ligne de mot (WL) à la fin d'une impulsion de contrôle (VPULSEi), en déchargeant une capacité parasite (Cs) de la ligne de mot, et
- mettre dans l'état passant l'interrupteur tire-bas (TDOWN) à la fin d'une impulsion de contrôle (VPULSEi).

21. Procédé selon la revendication 20, dans lequel l'interrupteur tire-bas (TDOWN) est dimensionné pour tirer la ligne de mot à un niveau bas en quelques nanosecondes après que la ligne de mot a été polarisée avec une tension (Vx).

22. Procédé selon l'une des revendications 20 et 21, comprenant des étapes consistant à :
- prévoir un pilote de ligne de mot (DRV) pour appliquer les impulsions de contrôle (VPULSEi) à la ligne de mot,
- agencer l'interrupteur tire-bas (TDOWN) dans le pilote de ligne de mot, et
- fournir au pilote de ligne de mot (DRV) un signal de contrôle (EPULSE) indiquant la fin d'une impulsion de contrôle (VPULSEi) et provoquant la fermeture de l'interrupteur tire-bas (TDOWN).

23. Procédé selon la revendication 22, comprenant une étape consistant à prévoir dans le pilote de ligne de mot (DRV) une porte inverseuse comprenant le transistor tire-bas (TDOWN) et un transistor tire-haut (TDRIVE) pour appliquer à la ligne de mot concernée les impulsions de contrôle (VPULSEi).

24. Procédé selon les revendications 22 et 23, comprenant une étape consistant à contrôler l'entrée de la porte inverseuse (IDRIVE) au moyen du signal de contrôle (EPULSE) et d'un signal de sélection (SWL) de la ligne de mot, de manière à :
- appliquer à la ligne de mot une impulsion de contrôle (VPULSEi) lorsque le signal de contrôle (EPULSE) indique le début d'une impulsion et que le signal de sélection (SWL) indique que la ligne de mot est sélectionnée, et
- tirer la ligne de mot à un niveau bas lorsque le signal de contrôle (EPULSE) indique que l'impulsion de contrôle (VPULSEi) est terminée.

25. Procédé selon l'une des revendications 18 à 24, dans lequel le point mémoire (P) d'une cellule mémoire est un point mémoire à changement de phase.

26. Procédé selon l'une des revendications 18 à 25, dans lequel le transistor de sélection (TS) d'une cellule mémoire est un transistor MOS.
